# EUROPEAN PATENT APPLICATION

(11) **EP 4 597 564 A1**
(43) Date of publication of application: **06.08.2025**
(21) Application number: 24155094.6
(22) Date of filing: 31.01.2024
(51) Int. Cl.: H01L 23/31, H01L 23/00

(54) **CHIP WITH CRACK AND DELAMINATION CONTROL FEATURE**

(71) Applicant: Nexperia B.V., 6534 AB Nijmegen (NL)
(72) Inventor: DULAL, Ravi Sharma, Manchester (GB); COUSINS, Ian, Manchester (GB)
(74) Representative: Pjanovic, Ilija

(57) **Abstract**

There is disclosed a chip for a semi-conductor device. The chip comprises a substrate that is formed from a semi-conductive material. The substrate defines a first major surface and a second major surface, the second major surface being opposed to the first major surface. The chip further comprises an epitaxial layer that is formed from a semi-conductive material. The epitaxial layer defines a first major surface and a second major surface, the second major surface being opposed to the first major surface. The second major surface of the epitaxial layer is secured to the first major surface of the substrate. The chip further comprises an insulation layer. The insulation layer defines a first major surface and a second major surface, the second major surface being opposed to the first major surface. The second major surface of the insulation layer is secured to the first major surface of the epitaxial layer. The chip further comprises a passivation layer. The passivation layer defines a first major surface and a second major surface, the second major surface being opposed to the first major surface. The second major surface of the passivation layer is secured to the first major surface of the insulation layer. The chip further comprises a first groove that extends into the first major surface of the insulation layer and at least to the first major surface of the epitaxial layer. The first groove is a continuous groove that extends inboard of and about a periphery of the chip. The chip further comprises a second groove that extends into the first major surface of the insulation layer and at least to the first major surface of the epitaxial layer. At least part of the second groove is disposed inboard of the first groove. The second groove extends inboard of and about the periphery of the chip. At least part of the passivation layer extends into the first groove. At least part of the passivation layer extends into the second groove.

## Description

### Field of Invention

The present invention relates to a chip for a semi-conductor device. The present invention also relates to a method for manufacturing a chip for a semi-conductor device.

### Background

Chips that are used in semi-conductor devices, such as MOSFET devices, include a passivation layer. The purpose of the passivation layer is to protect the chip from the external environment to, for example, reduce the potential for moisture and/or dust to come into contact with the chip. Separation of the passivation layer from the chip is undesirable because this presents a potential point of ingress for dust and/or moisture.

There exists a need to overcome the disadvantages associated with existing chips for semi-conductor assemblies, whether identified herein or otherwise.

### Summary

In a first aspect of the invention, there is provided a chip for a semi-conductor device. The chip comprises a substrate that is formed from a semi-conductive material. The substrate defines a first major surface and a second major surface, the second major surface being opposed to the first major surface. The chip further comprises an epitaxial layer that is formed from a semi-conductive material. The epitaxial layer defines a first major surface and a second major surface, the second major surface being opposed to the first major surface. The second major surface of the epitaxial layer is secured to the first major surface of the substrate. The chip further comprises an insulation layer. The insulation layer defines a first major surface and a second major surface, the second major surface being opposed to the first major surface. The second major surface of the insulation layer is secured to the first major surface of the epitaxial layer. The chip further comprises a passivation layer. The passivation layer defines a first major surface and a second major surface, the second major surface being opposed to the first major surface. The second major surface of the passivation layer is secured to the first major surface of the insulation layer. The chip further comprises a first groove that extends into the first major surface of the insulation layer and at least to the first major surface of the epitaxial layer. The first groove is a continuous groove that extends inboard of and about a periphery of the chip. The chip further comprises a second groove that extends into the first major surface of the insulation layer and at least to the first major surface of the epitaxial layer. At least part of the second groove is disposed inboard of the first groove. The second groove extends inboard of and about the periphery of the chip. At least part of the passivation layer extends into the first groove. At least part of the passivation layer extends into the second groove.

The first groove and the second groove being said to extend about the periphery of the chip may be understood to mean that the grooves are disposed in an edge region of the chip.

One or more functional circuits may be disposed on the epitaxial layer. The one or more functional circuits may be disposed inboard of the first groove, and inboard of the second groove.

All of the grooves may have an equal depth.

The first groove and the second groove may extend at least partially into the epitaxial layer.

The first groove may extend about an entirety of the periphery of the chip.

The second groove may extend about an entirety of the periphery of the chip.

The second groove may not adjoin the first groove.

During operation, the chip is subject to temperature fluctuations as a result of, for example, changing environments and/or heat generated by the semi-conductor device itself. These temperature fluctuations result in the expansion and contraction of the chip, which subjects the chip to internal stresses. The internal stresses increase the likelihood of delamination of the components of the chip. Since the chip comprises first and second grooves into which the passivation layer extends, the likelihood of separation of the passivation layer from the insulation layer is advantageously reduced. This is because the grooves increase the contact area between the passivation layer and the insulation layer. Increasing the contact area between the passivation layer and the insulation layer increases the strength of the bond between the two layers, which decreases the likelihood of separation of the passivation layer from the insulation layer.

During manufacture, the chip is separated from a wafer that comprises an array of chips. Typically, this is done using a sawing tool. During separation, cracks may initiate. Advantageously, since the first groove is continuous, the likelihood of propagation of any cracks may that initiate during separation of the chip from the sheet is reduced. This improves manufacturing efficiency as fewer defective chips are manufactured.

The second groove may be discontinuous.

The second groove being discontinuous may be understood to mean that the second groove is formed of a plurality of groove sections that are spaced apart from one another.

Where the second groove is discontinuous, the likelihood of propagation of separation of the passivation layer from the insulation layer is advantageously reduced. This is because, if the passivation layer separates from the insulation layer in the region of one of the sections of the second groove, the likelihood of this separation going on to an adjacent section of the second groove is reduced. This is as compared to if each section of the second grove were extend continuously from an adjacent section. Separation of a limited portion of the passivation layer from the insulation layer is acceptable with regards to the integrity of the chip. Therefore, where the second groove is discontinuous, the robustness of the chip is advantageously improved.

Furthermore, where the second groove is discontinuous, the surface area of the second groove can be greater than if the second groove were continuous. This further increases the bond strength between the passivation layer and the insulation layer, which further reduces the likelihood of separation of the passivation layer from the insulation layer.

The second groove may be formed of a plurality of groove sections. In plan view, each groove section may be circular, polygonal, annular, cross-shaped, dot-shaped or linear.

The above geometries for each groove section of the second groove are particularly effective at achieving the advantages of the present invention.

Plan view may be understood to refer to a view of the insulation layer that is perpendicular to a major surface of the insulation layer.

Throughout this document, may be understood to a shape having at least two dimensions that are equal in magnitude to one another.

The first groove may follow wave-shaped path.

Where the first groove defines a wave-shaped path, the contact area between the passivation layer and the first groove is increased as compared to a linear path. Therefore, where first groove defines a wave-shaped path, the likelihood of separation of the passivation layer from the insulation layer is advantageously further reduced.

The first groove may follow a sinusoidally-shaped path, a square wave-shaped path, a triangular wave-shaped path, or a saw tooth-shaped path.

The above geometries for the first groove are particularly effective at achieving the advantages of the present invention.

Each groove section of the plurality of groove sections of the second groove may be disposed between an inboard extremity and an outboard extremity of the path defined by the first groove .

Where each groove section of the second groove is linear in plan view, each groove section of the second groove may extend parallel to or non-parallel to an adjacent portion of the first groove.

Each groove section of the second groove may extend perpendicular to an adjacent portion of the first groove.

The above arrangements are particularly effective at achieving the advantages of the present invention.

The chip may further comprise a third groove that extends into the first major surface of the insulation layer. The third groove may extends inboard of and about a periphery of the chip. At least part of the passivation layer may extends into the third groove. The third groove is a continuous groove.

The third groove may be disposed outboard of the one or more functional circuits of the epitaxial layer.

Where a third groove is provided, the contact area between the passivation layer and the insulation layer is further increased. This further reduces the likelihood of separation of the passivation layer from the insulation layer.

The third groove may be disposed inboard of the first groove. The third groove may be disposed inboard of the second groove. Each groove section of the second groove extends non-parallel to an adjacent portion of the first groove. Each groove section of the second groove may adjoin and extend between the first groove and the third groove.

The third groove may be disposed outboard of the first groove.

The second groove may be continuous.

Where the second groove is continuous, the contact area between the passivation layer and the first and second grooves is increased as compared to where the second groove is discontinuous. This increases the bond strength between the passivation layer and the insulation layer, which reduces the likelihood of separation of the passivation layer from the insulation layer.

The first groove may follow a wave-shaped path that defines a plurality apexes. The second groove may follows a wave-shaped path that defines a plurality of apexes. Alternative apexes of the first groove may adjoin alternative apexes of the second groove.

The plurality of apexes of the first groove may be understood to refer to the peaks or troughs defined by the wave-shaped path followed by the first groove. The plurality of apexes of the second groove may be understood to refer to the peaks or troughs defined by the wave-shaped path followed by the second groove. Put another way, the plurality of apexes may refer to the inboard and outboard extremities of the paths followed by the first groove and by the second groove.

The second groove may be disposed inboard of the first groove.

The entirety of the second groove may be disposed inboard of the first groove.

As mentioned above, the first groove being continuous reduces the likelihood of crack propagation. The second groove being disposed inboard of the first groove further reduces this, in particular where the second groove is discontinuous. This is because the discontinuities of the second groove may allow crack propagation. Therefore, the first groove being outboard of the second groove further reduces the likelihood of crack propagation.

The passivation layer may be formed from polyimide.

Polyimide is a desirable material to use for the passivation layer because it is less susceptible to cracking in use as compared to other materials which may be used for the passivation layer, such as silicon nitride. Cracking of the passivation layer is undesirable because it can lead to failure of the chip, and of the semi-conductor device that the chip forms a part of, due to, for example, moisture ingress. Therefore, the passivation layer being formed of polyimide increases the robustness of the chip.

Furthermore, the difference in the coefficient of thermal expansion of polyimide and the coefficient of thermal expansion of a cover that is applied to the clip during assembly into a semi-conductor device is smaller than that for conventional passivation layer materials. Where this difference is reduced, the internal stresses that the device is subject to in use are reduced, which reduces the likelihood of delamination of the cover from the passivation layer.

In a second aspect of the invention there is provided a method of manufacturing a chip for a semi-conductor device. The method comprises providing a substrate that defines a first major surface and a second major surface, the second major surface being generally opposed to the first major surface. The substrate is formed from a semi-conductive material. The method further comprises providing an epitaxial layer that defines a first major surface and a second major surface, the second major surface being generally opposed to the first major surface. The epitaxial layer is formed from a semi-conductive material. The epitaxial layer comprises a plurality of active cells. The epitaxial layer is provided such that the second major surface of the epitaxial layer is secured to the first major surface of the substrate. The method further comprises providing an insulation layer that defines a first major surface and a second major surface, the second major surface being generally opposed to the first major surface. The method further comprises securing the second major surface of the insulation layer to the first major surface of the epitaxial layer. The method further comprises applying a first photolithography resist layer to the first major surface of the insulation layer and subsequently patterning the first photolithography resist layer. The method further comprises forming a plurality of recesses that extend through the insulation layer at least to the epitaxial layer. The position of the plurality of recesses corresponds to a respective active cell of the plurality of active cells. The method further comprises forming a first groove that extends into the first major surface of the insulation layer and at least to the epitaxial layer. The first groove is a continuous groove that extends inboard of and about a periphery of the chip. The method further comprises forming a second groove that extends into the first major surface of the insulation layer and at least to the epitaxial layer. At least part of the second groove is disposed inboard of the first groove. The second groove extends inboard of and about the periphery of the chip. The pattern that is applied to the first photolithography resist layer corresponds to the plurality of recesses, the first groove, and the second groove. The method further comprises removing the first photolithography resist layer. The method further comprises providing a conductive layer, the conductive layer defining a first side and a second side. The first side of the conductive layer is secured to the first major surface of the insulation layer and extends into the plurality of recesses, the first groove, and the second groove. The method further comprises applying a second photolithography resist layer to the first side of the conductive layer and subsequently patterning the second photolithography resist layer. The method further comprises removing the conductive layer from the region or regions corresponding to the first groove and the second groove and from within the first groove and the second groove. The pattern that is applied to the second photolithography resist layer corresponds to the region or regions corresponding to the first groove and the second groove. The method further comprises removing the second photolithography resist layer. The method further comprises providing a passivation layer. The passivation layer is secured to the second side of the conductive layer and extends into the first groove and the second groove.

The conductive layer may be formed of multiple constituent layers or portions. Each layer or portion may be formed from a different conductive material.

Patterning of the photolithography resist layer involves removing a portion or portions of the photolithography resist layer.

The plurality of recesses may extend into the epitaxial layer.

The pattern that is applied to the first photolithography resist layer corresponding to the region or regions of the plurality of recesses, the first groove, and the second groove may be understood to mean that the portion or portions that are removed correspond in shape, when viewed in plan view, to the plurality of recesses, the first groove, and the second groove.

The pattern that is applied to the second photolithography resist layer corresponding to the region or regions of the first groove and the second groove may be understood to mean that the portion or portions that are removed correspond in shape, when viewed in plan view, to the first groove and the second groove.

The plurality of recesses, the first groove, and the second groove may be formed via a dry etching process, such as plasma etching.

The conductive layer may be removed via a dry etching process, such as plasma etching. The conductive layer may be removed via a wet etching process, such as acid etching.

The conductive layer may be removed from the region or regions corresponding to the first groove and the second groove and from within the first groove and the second groove via etching, preferably via wet etching or via isotropic dry etching.

Subsequent to removing the conductive layer and prior to providing the passivation layer, an adhesive layer, which may be formed of silicon nitride, may be applied to the first groove and to the second groove.

The plurality of recesses may be formed via etching. The first groove may be formed via etching. The second groove may be formed via etching.

It will be appreciated that features discussed in relation to one aspect of the invention may be combined with a different aspect of the invention.

### Brief Description of the Drawings

Embodiments of the present invention will now be described with reference to the accompanying drawings, in which:
Figure 1 shows a perspective view of a semi-conductor device according to an embodiment of the present invention;
Figure 2 shows a cross-sectional view of a portion of a chip of the semiconductor device of Figure 1;
Figure 3 shows a plan view of the chip of Figure 2;
Figures 4 to 8 show portions of grooves that may be implemented in the chip of Figures 2 and 3; and
Figures 10 to 17 show a method of manufacture of the chip of Figures 2 and 3.

### Detailed Description

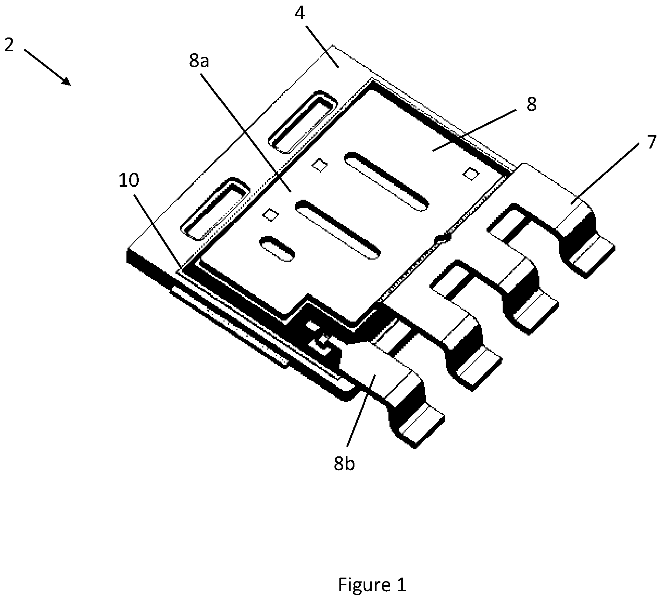

Figure 1 shows a semiconductor device 2. The semi-conductor device 2 is a MOSFET. The semi-conductor device 2 comprises a lead frame 4. The semi-conductor device 2 comprises a chip 6. The semi-conductor device 2 comprises a clip 8. The semiconductor device 2 comprises a cover (not shown in Figure 1).

The lead frame 4 serves as a base of the semi-conductor device 2 to which other components of the device are attached. The lead frame 4 is manufactured from a conductive material such as copper (including a copper alloy).

The chip 6 is secured to the lead frame 4. The chip 6 is secured to the lead frame 4 by virtue of a first solder layer 10. The chip 6 may be a single component or may comprise multiple constituent components. The chip 6 is made of a semi-conducting material. For example, the chip 6 may be made from silicon, silicon carbide or gallium nitride, or any other suitable material. The chip 6 has a functional circuit fabricated thereon. The chip 6 is generally rectangular but may be any other suitable shape. The chip 6 is plate like in shape.

In the embodiment shown in Figure 1, the clip 8 comprises two constituent parts 8a, 8b, such that the device 2 is a three terminal device. However, in some embodiments, the clip 8 may comprise any suitable number of constituent parts. For example, the clip 8 may comprise only a single constituent part such that the device 2 is a two terminal device. In some embodiments, the clip 8 need not be provided, and wires may be used in its place such that the device 2 is a wire-bonded device.

The cover encapsulates the remaining components of the semi-conductor device 2 (i.e., the lead frame 4, the chip 6, and the clip 8). The cover may also be referred to as an isolator, a casing, or an encapsulant. A plurality of leads 7 (only one of which is labelled in Figure 1) of the clip 8 extend through the cover. This allows the leads 7 to be connected to the external circuit (not shown). The cover may be made from any suitable electrically isolating material, such as an epoxy.

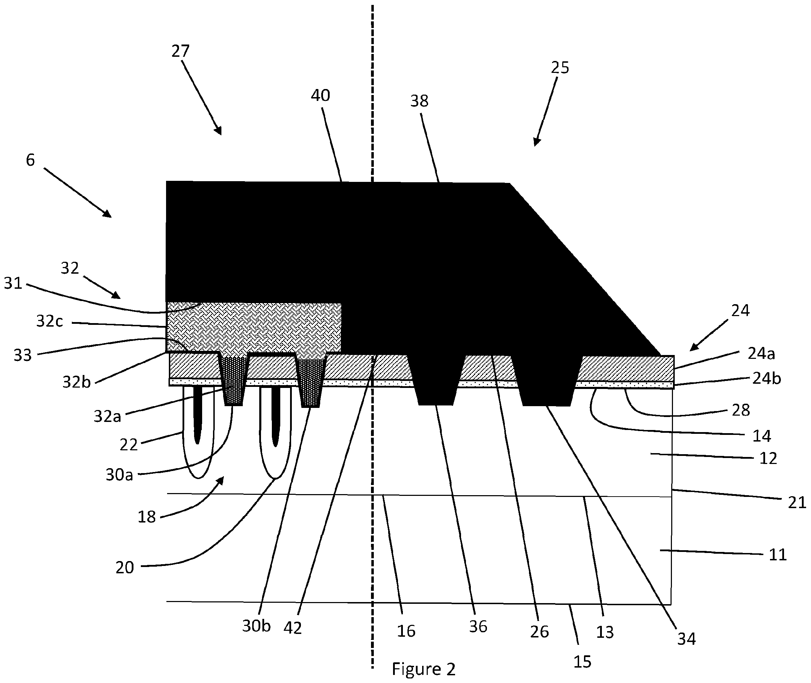

Referring now to Figure 2, a cross-sectional view of a peripheral portion of the chip 6 is shown. The chip 6 defines a periphery 21.

The chip 6 comprises a substrate 11. The substrate 11 defines a first major surface 13. The substrate 11 comprises a second major surface 15. The second major surface 15 is generally opposed to the first major surface 13. The substrate 11 is formed from a semi-conductive material such as, for example, silicon.

The chip 6 further comprises an epitaxial layer 12. The epitaxial layer 12 defines a first major surface 14. The epitaxial layer 12 comprises a second major surface 16. The second major surface 16 is generally opposed to the first major surface 14. The second major surface 16 of the substrate 12 is secured to the first major surface 13 of the epitaxial layer 11. The epitaxial layer 12 is formed from a semi-conductive material such as, for example, silicon. An active cell 18 is formed in the epitaxial layer 12. Although only one active cell 18 is visible in Figure 2, the epitaxial layer 12 may comprise a plurality of active cells. It will be appreciated that the view of Figure 2 shows only a part of the chip 6, and so further active cells are provided that are not visible in the view of Figure 2. The active cell 18 comprises a first gate 20 and a second gate 22. The second gate 22 is disposed outboard of the first gate 20. That is to say, the second gate 22 is disposed closer to the periphery 21 of the chip 6 than the first gate 20.

The chip 6 further comprises an insulation layer 24. The insulation layer 24 may also be referred to as an inter-layer dielectric. The insulation layer 24 comprises a first portion 24a and a second portion 24b. The first portion 24a may be formed from phosphorus doped silicon glass. The second portion 24b may be formed from undoped silicon glass. The insulation layer 24 defines a first major surface 26. The insulation layer defines a second major surface 28. The first major surface 26 of the insulation layer 24 is generally opposed to the second major surface 28 of the insulation layer 24.

A first recess 30a extends through the insulation layer 24 and at least partially into the epitaxial layer 12. The first recess 30a is disposed between the first gate 20 and the second gate 22 of the active cell 18. A second recess 30b extends through the insulation layer 24 and at least partially into the epitaxial layer 12. The second recess 30b is disposed adjacent to, and outboard of, the first gate 20 of the active cell. The second recess 30b is the outermost (i.e., disposed closest to the periphery 21 of the chip 6) recess. The region of the chip 6 that is outboard of the second recess 30b may be referred to as the non-active region 25 of the chip 6. The region of the chip 6 that includes, and is inboard of, the second recess 30b may be referred to as the active region 27 of the chip 6.

The chip 6 further comprises a conductive layer 32. The conductive layer defines a first side 31 and a second side 33. The second side 33 is generally opposed to the first side 31. The conductive layer 32 comprises a first portion 32a, a second portion 32b, and a third portion 32c. The third portion 32c defines the first side 31 of the conductive layer 32. The second portion 32b defines the second side 33 of the conductive layer 32. The first portion 32a of the conductive layer 32a is disposed within the first recess 30a and the second recess 30b of the active cell 18. The first portion 32a of the conductive layer 32 is formed from tungsten. However, any other suitable material may be used. The first portion 32a of the conductive layer 32 comprises two constituent parts. Each part of the first portion 32a of the conductive layer 32 may be referred to as a plug.

The second portion 32b of the conductive layer 32b is secured to the first major surface 26 of the insulation layer 24. The second portion 32b of the conductive layer 32 also extends into the first recess 30a and the second recess 30b of the active cell 18. The second portion 32b of the conductive layer 32 interfaces the surfaces of the recesses 30a, 30b. The second portion 32b of the conductive layer 32 is secured to the surfaces of the recesses 20a, 20b. The second portion 32b of the conductive layer 32 is in contact with the first portion 32a of the conductive layer 32. The second portion 32b of the conductive layer 32 is made from titanium or titanium nitride. However, any suitable material may be used.

The third portion 32c of the conductive layer 32 is secured to the second portion 32b of the conductive layer 32, and to the first portion 32a of the conductive layer 32. The third portion 32c of the conductive layer is at least partially disposed in the recesses 30a, 30b, but this need not be the case. The third portion 32c of the conductive layer 32 is preferably formed from an aluminium-copper compound.

The chip 6 further comprises a first groove 34. The first groove 34 is disposed in the non-active region 25 of the chip 6. The first groove 34 extends into the insulation layer 24. In particular, the first groove 34 extends into the first major surface 26 of the insulation layer 24. The first groove 34 extends all the way through the insulation layer 24. The first groove 34 extends partially into the epitaxial layer 12. The first groove 34 extends into the first major surface 14 of the epitaxial layer 12. However, in some embodiments the first groove 34 need only extend at least to the epitaxial layer 12. That is to say, a base surface of the first groove 34 may be defined by the first major surface 14 of the epitaxial layer 12. As will be discussed in more detail below, the first groove 34 is a continuous groove, and extends about and inboard of a periphery of the chip 6. Since the first groove 34 is a continuous groove, the likelihood of propagation of any cracks that may initiate at the periphery 21 of the chip is advantageously reduced.

Throughout this document, the term 'continuous' with respect to grooves may be understood to mean that there are no discontinuities in the channel defined by the groove.

The chip 6 further comprises a second groove 36. The second groove 36 is disposed in the non-active region 25 of the chip 6. The second groove 36 extends into the first major surface 26 of the insulation layer 24. The second groove 36 is disposed inboard of the first groove 34. The second groove 36 extends all the way through the insulation layer 24. The second groove 36 extends partially into the epitaxial layer 12. The second groove 36 extends into first major surface 14 of the epitaxial layer. However, in some embodiments the second groove 36 need only extend at to the epitaxial layer 12.

That is to say, a base surface of the second groove 36 may be defined by the first major surface 14 of the epitaxial layer 12. The second groove 36 extends about and inboard of a periphery of the chip 6. In this embodiment, the second groove 36 is a discontinuous groove. However, in other embodiments, the second groove may be a continuous groove.

Throughout this document, the term 'discontinuous' with respect to grooves may be understood to mean that the groove is formed of multiple, separately formed, portions.

The chip 6 further comprises a passivation layer 38. Preferably, the passivation layer 38 is formed from polyimide. However, any suitable material may be used for the passivation layer such as a polybenzoxazole (PBO). The passivation layer 38 defines a first side 40, which may also be referred to as a first major surface of the passivation layer. The passivation layer defines a second side 42, which may also be referred to as a second major surface of the passivation layer. The second side 42 is generally opposed to the first side 40. The second side 42 of the passivation layer 38 is secured to the first major surface 26 of the insulation layer 24. The second side 42 of the passivation layer 38 is also secured to the third portion 32c of the conductive layer 32. At least part of the passivation layer 38 extends into the first groove 34 and into the second groove 26. Preferably, the first groove 34 and the second groove 36 are filled by the passivation layer 38.

The purpose of the first groove 34 and of the second groove 36 is to improve adhesion between the passivation layer 38 to the insulation layer 24. The provision of two grooves advantageously increases the contact area between the passivation layer and the insulation layer 24. This advantageously reduces the likelihood of separation of the passivation layer 38 from the insulation layer 24.

In some embodiments, an adhesive layer (not shown) may be provided between the passivation layer 38 and the insulation layer 24. The adhesive layer may be formed from silicon dioxide or silicon nitride. Where provided, the adhesive layer improves adhesion between the passivation layer 38 and the insulation layer 24.

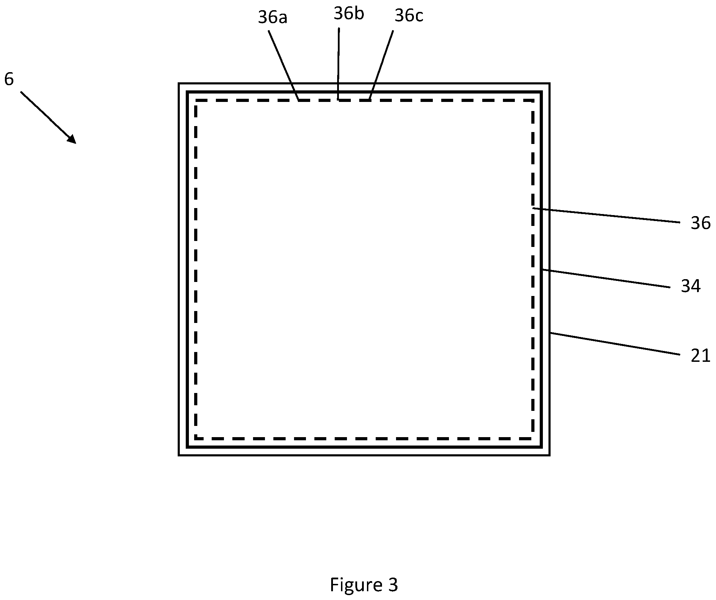

Figure 3 shows a plan view of the chip 6. In Figure 3, the passivation layer 38, the conductive layer 32, and the active cells 18 are not depicted for clarity. In this embodiment, the entirety of the second groove 36 is disposed inboard of the first groove 34. As can also be seen, and as was discussed above, the first groove 34 is a continuous groove. The first groove 34 is linear. The first groove 34 is disposed inboard of the periphery 21 of the chip 6. The second groove 36 is discontinuous. Therefore, the second groove 36 is formed of a plurality of separately formed groove sections 36a, 36b, 36c (only three of which have been labelled in Figure 3). Each groove section of the plurality of groove sections 36a-c of the second groove 36 is linear. Each groove section of the plurality of groove sections 36a-c extends parallel to an adjacent portion of the first groove 34. However, in some embodiments, discussed below, at least part of the second groove 36 need not extend parallel to an adjacent portion of the first groove 34. Each groove section of the plurality of groove sections 36a-c of the second groove 36 is in the form of a dash. The geometries of the first groove 34 and of the second groove 36, including the paths followed by the first groove 34 and second groove 36, can be varied in order to optimize this adhesion. Furthermore, although only two grooves 34, 36 are depicted in Figures 2 and 3, further additional grooves may be provided.

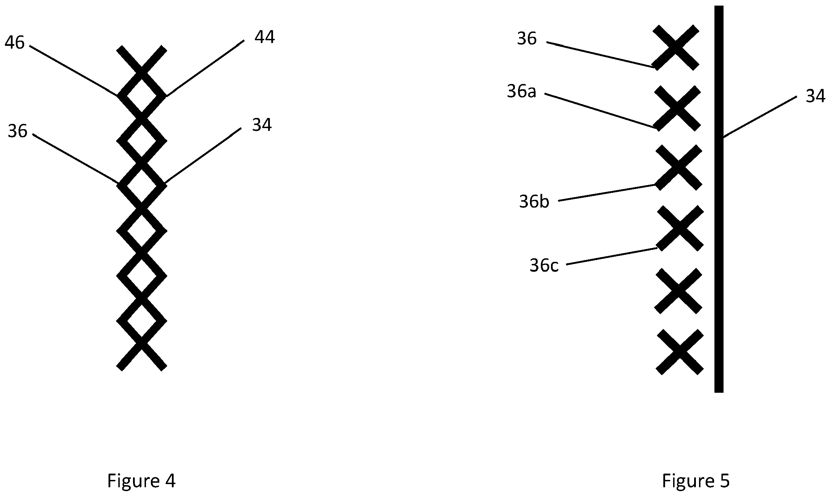

Figures 4 to 9 show alternative groove geometries. Each geometry may be implemented in the chip 6 shown in Figures 1 to 3. Only a portion of each geometry is shown. For each geometry, when applied to the chip, the grooves extend about the periphery of the chip 6 (i.e., about the entire periphery of the chip 6). Each geometry is shown in plan view. Throughout this document, the term plan view maybe understood to refer to a view of the groove that is perpendicular to the first major surface of the insulation layer.

Figure 4 shows a first alternative geometry. In this embodiment, both the first groove 34 and the second groove 36 are continuous grooves. The first grooves 34 follows a wave-shaped path. As depicted, the wave-shape of the path followed by the first groove 34 is a triangular wave-shaped path. However, in other embodiments, the path followed by the first groove 34 may be a sinusoidally shaped path, a square wave-shaped path, a saw tooth-shaped path, or any other wave-shape. The second grooves 36 follows a wave-shaped path. As depicted, the wave-shape of the path followed by the second groove 36 is a triangular wave-shaped path. However, in other embodiments, the path followed by the second groove 36 may be a sinusoidally shaped path, a square wave-shaped path, or a saw tooth-shaped path. The wave form of the path followed by the first groove 34 need not be the same as the wave form of the path followed by the second groove 36. For example, the first groove 34 may follow a sinusoidally shaped path and the second groove 36 may follow a square wave shaped path. When applied to the chip 6, an amplitude direction of the wave paths defined by the grooves 34, 36 extends generally parallel to the first major surface of the insulation layer (not shown in Figure 4).

The first groove defines a plurality of apexes 44 (only one of which is labelled in Figure 4). The second groove 36 defines a plurality of apexes 46 (only one of which is labelled in Figure 4). The term apexes may be understood to refer to the peaks or troughs that are defined by the wave-shaped paths followed by the grooves 34, 36. Put another way, the plurality of apexes 44, 46 may refer to the inboard and outboard extremities of the paths followed by the first groove 34 and the second groove 36. The first groove 34 and the second groove 36 adjoin one another. In particular, alternative apexes of the plurality of apexes 44 of the first groove adjoin alternative apexes of the plurality of apexes 46 of the second groove.

Figure 5 shows a further alternative groove geometry. The first groove 34 is a continuous, linear, groove. In some embodiments, the first groove 34 may follow a wave-shaped path. The wave may take any of the forms discussed above in relation to Figure 4. In this embodiment, the second groove 36 is a discontinuous groove. In this embodiment, each groove section of the plurality of groove sections 36a-c of the second groove 36 is cross-shaped in plan view. The second groove 36 does not adjoin the first groove 34, but may do so in some embodiments.

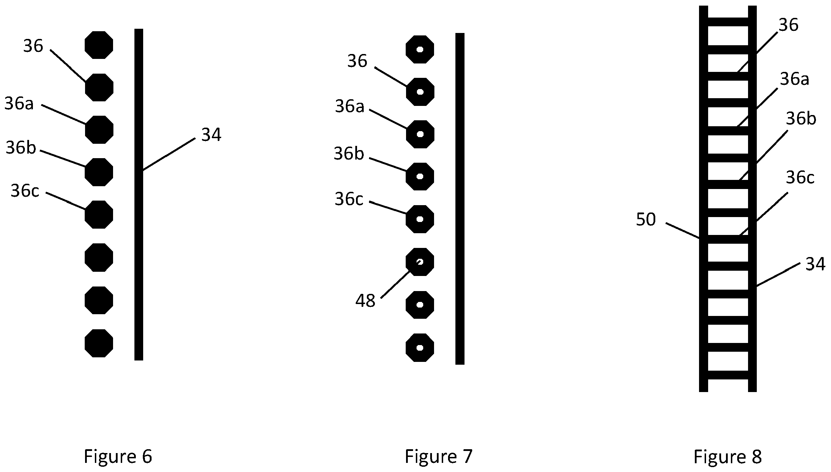

Figure 6 shows a further alternative groove geometry. In this embodiment, the first groove is a continuous, linear, groove. In some embodiments, the first groove 34 may follow a wave-shaped path. The wave may take any of the forms discussed above in relation to Figure 4. In this embodiment, the second groove 36 is a discontinuous groove, and so comprises a plurality of groove sections 36a-c. Each groove section of the plurality of groove sections 36a-c are polygonal in plan view. In the depicted embodiment, the polygonal shape defied by each of the groove sections 36a-c is an octagon. However, any other suitable polygonal shape may be used. For example, each groove section of the plurality of groove sections 36a-c may be triangular, square, or pentagonal in plan view. Each section being octagonal is preferred because this increases the surface area of each section. In some, non-depicted, embodiments each groove section of the plurality of groove sections 36a-c may be circular in plan view.

Figure 7 shows a further alternative groove geometry. In this embodiment, the first groove 34 defines a continuous, linear path. In some embodiments, the first groove 34 may follow a wave-shaped path. The wave may take any of the forms discussed above in relation to Figure 4. In this embodiment, the second groove 36 is a discontinuous groove. The second groove 36 of this embodiment is similar to the second groove of Figure 6. In this embodiment, the groove sections 36a-c of the second groove each comprise a central pillar 48. The central pillar 48 of each groove section of the plurality of groove sections 36a-c advantageously increases the surface area of each of the groove sections. This further improves adhesion between the passivation layer (not shown in Figure 7) and the insulation layer (not shown in Figure 7). In plan view, a periphery of the each groove section of the plurality of groove sections 36a-c of the second groove is polygonal. Each groove section of the plurality of groove sections 36a-c of the second groove may be said to be annular.

Figure 8 shows a further alternative groove geometry. In this embodiment, a third groove 50 is provided. The third groove 50 is disposed inboard of the first groove 34 and inboard of the second groove 36. The third groove 50 is a continuous groove. The third groove 50 is a linear groove. In this embodiment, the first groove 34 is a continuous, linear, groove. In some embodiments, the first groove 34 and/or the third groove 50 may follow a wave-shaped path. The wave may take any of the forms discussed above in relation to Figure 4. In this embodiment, the second groove 36 is a discontinuous groove. Each groove section of the plurality of groove sections 36a-c of the second groove 36 is linear. Each groove section of the plurality of groove sections 36a-c of the second groove 36 extends perpendicular to an adjacent portion of the first groove 34. However, in other embodiments, each groove section of the plurality of groove sections 36a-c of the second groove 36 may extend at any non-parallel angle, preferably an internal angle of at least 25 degrees, with respect to an adjacent portion of the first groove 34. Each groove section of the plurality of groove sections 36a-c of the second groove 36 is perpendicular to an adjacent portion of the third groove 50. However, in other embodiments, each groove section 36-c of the second groove 36 may extend at any non-parallel angle, preferably an internal angle of at least 45 degrees, with respect to an adjacent portion of the third groove 50. Each groove section of the plurality of groove sections 36a-c of the second groove 36 adjoins and extends between the first groove 34 and the third groove 50. In some embodiments, the third groove 50 need not be provided. In some embodiments, the second groove 34 may take any of the geometries disclosed with reference to Figures 4 to 7.

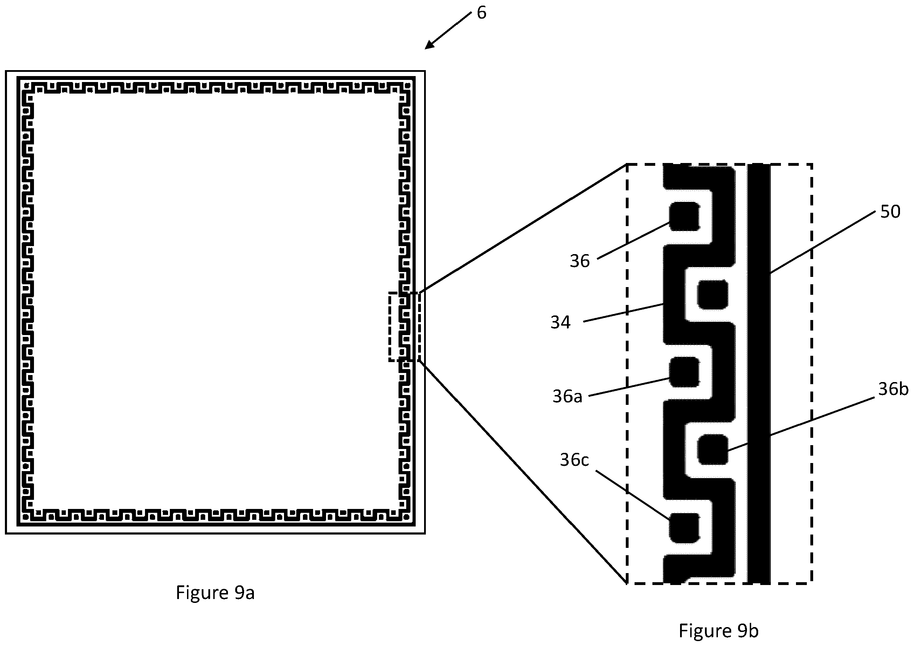

Figures 9a and 9b show an alternative embodiment of the chip 6 having a further alternative groove geometry. As with Figure 3, the passivation layer 38, the conductive layer 32, and the active cells 18 are not depicted for clarity. Figure 9a shows a plan view of the chip 6. Figure 9b shows a detailed view of a portion of the Figure 9a. In this embodiment, a third groove 50 is also provided. The third groove 50 is disposed outboard of the first groove 34 and outboard of the second groove 36. The third groove 50 is a linear groove. The first groove 34 is a wave-shaped groove. The wave-shaped path followed by the first groove 34 is a square wave. However, the wave shape followed by the first groove 34 may be any of the wave shapes discussed above in relation to Figure 4. The vertices of the first groove 34 are rounded. This advantageously improves the flow of the passivation layer into the first groove 34, which improves adhesion between the passivation layer and the first groove 34. The second groove 36 is a discontinuous groove. Each groove section 36 a-c of the second groove 36 is square in plan view. However, any other suitable shape may be taken by the groove sections 36 a-c of the second groove. Each groove section of the plurality of groove sections 36a-c of the second groove 36 are disposed between the inboard and outboard extremities of the first groove 34. The groove sections of the plurality of groove sections 36a-c of the second groove 36 may be said to be interdigitated with the first groove. In some embodiments, the third groove 50 need not be provided.

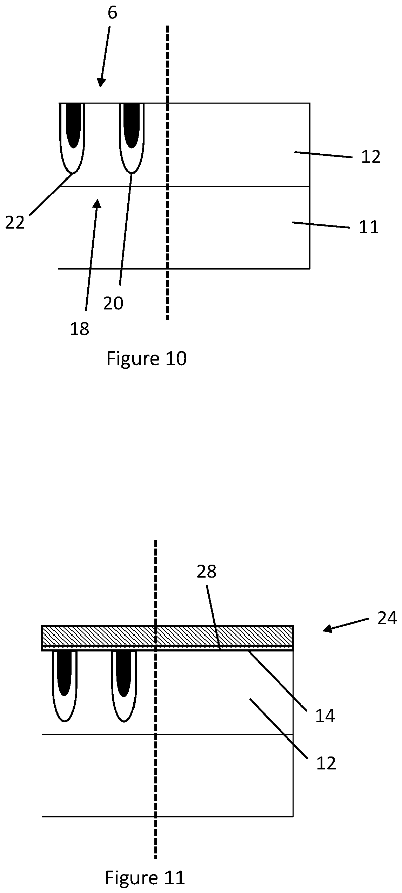

The process by which the chip 6 is manufactured will now be discussed with reference to Figures 10 to 16. In a first step, shown in Figure 10, the substrate 11 and the epitaxial layer 12 are provided. The epitaxial layer 12 is secured to the substrate 11. As can be seen, the epitaxial layer 12 has already been provided with the first gate 20 and the second gate 22 of the active cell 18 in a conventional manner.

Next, as shown in Figure 11 the insulation layer at 24 is provided such that the second major surface 28 of the insulation layer 24 is secured to the first major surface 14 of the epitaxial layer 12.

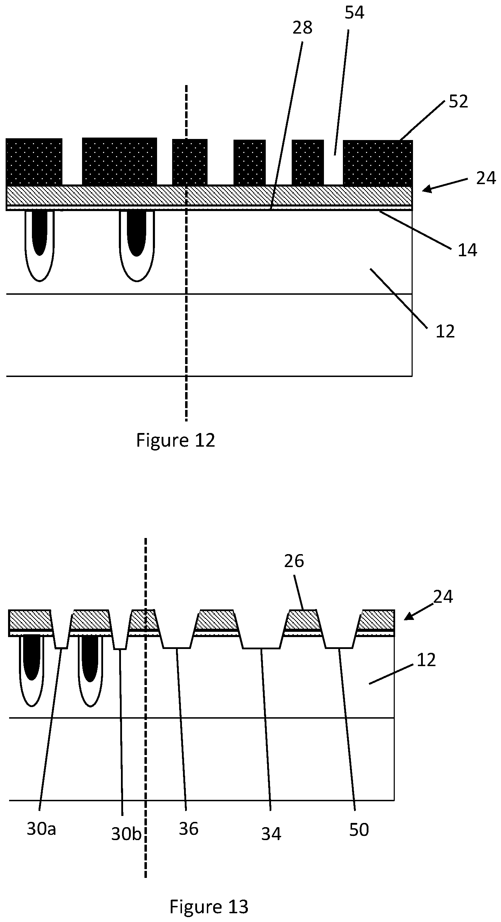

Next, as shown in Figure 12, a first photolithography resist layer 52 is applied to the first major surface 26 of the insulation layer 24. The first photolithography resist layer 52 is patterned and so comprises a plurality of apertures 54 (only one of which is labelled in Figure 12). The pattern of the first photolithography resist layer 52, that is to say, the position of the apertures 54, corresponds to the positions of the plurality of recesses and grooves (not present at this stage).

Next, as shown in Figure 13, the first recess 30a, the second recess 30b, the first groove 34, the second groove 36, and the third groove 50 are formed such that each of the recesses 30a, 30b, and each of the grooves 34, 36, 50 extend into the first major surface 26 of the insulation layer 24. In the depicted embodiment, the recesses 30a, 30b and the grooves 34, 36, 50 also extend into the epitaxial layer 12. However, as discussed above, this may not be the case for the grooves 34, 36, 50, which may only extend to the epitaxial layer 12. The first recess 30a, the second recess 30b, the first groove 34, the second groove 36, and the third groove 50 are formed via plasma etching. Since the first photolithography resist layer 52 is applied to the first major surface 26 of the insulation layer 24, the plasma etching process is only effective in the regions corresponding to the plurality of apertures 54. The first photolithography resist layer 52 is then removed.

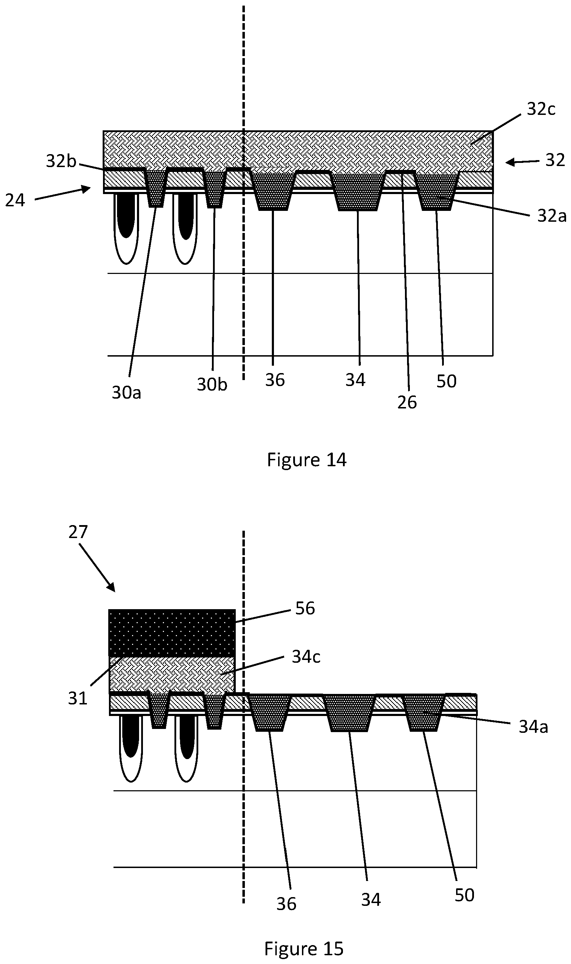

Next, as shown in Figure 14, the conductive layer 32 is provided. The conductive layer 32, in particular the second portion 32b of the conductive layer 32, is secured to the first major surface 26 of the insulation layer 24. The second portion 32b of the conductive layer 32 extends into the first recess 30a, the second recess 30b, the first groove 34, the second groove 36, and the third groove 50. The first portion 32a of the conductive layer is disposed in the first recess 30a, the second recess 30b, the first groove 34, the second groove 36, and the third groove 50. The third portion 32c is secured to the first portion 32a and to the second portion 32b.

Next, as shown in Figure 15, a second photolithography resist layer 56 is applied to the first side 31 of the conductive layer 32. The second photolithography resist layer 56 is applied to the active region 27 of the chip 6.

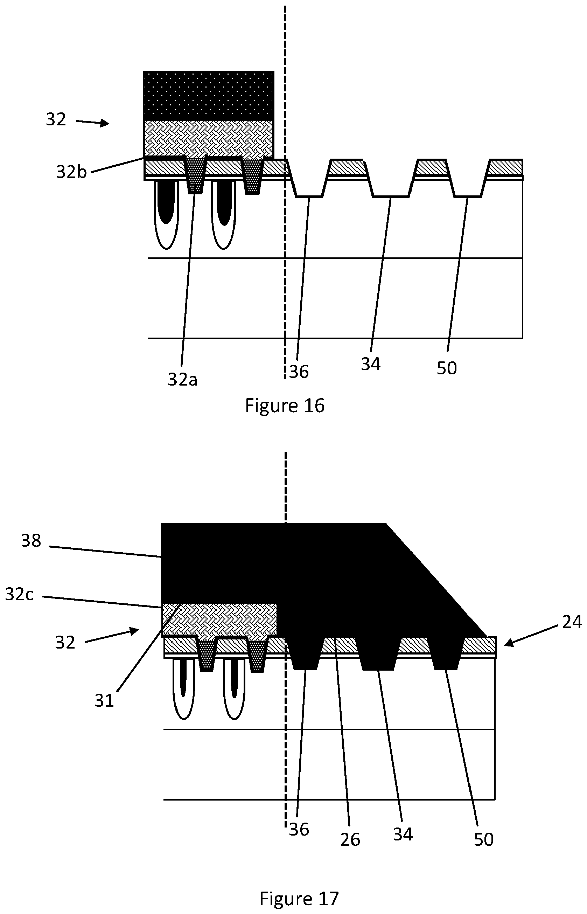

Next, as shown in Figure 16, the first portion 32a of the conductive layer 32 is removed from the first groove 34, the second groove 36, and the third groove 50. This may be achieved via a wet etching process, such as acid etching. Alternative etching methods, such as plasma etching, may be used. A photolithography resist layer is not required at this stage due to the selectivity of the etching, which removes the material of the first portion 32a of the conductive layer 32 first. In addition, the second portion 32b of the conductive layer 32 is removed from the region corresponding to the first groove 34, the second groove 36, and the third groove 50. The second portion 32b may be removed via an isotropic dry etch, such as plasma etching. Removal of the second portion 32b take place subsequent to removal of the first portion 32a.

Next, as shown in Figure 17, the passivation layer 38 is provided. The passivation layer 38 is secured to the first side 31 of the conductive layer 32. The passivation layer 38 extends into the first groove 34, the second groove 36, and the third groove 50. The passivation layer also adheres to the first major surface 26 of the insulation layer 24.

Although the above discussion of the method of manufacturing the chip 6 has been discussed in relation to three grooves being provided, it will be appreciated that the above method equally applies to where only two grooves are provided.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A chip for a semi-conductor device, the chip comprising:
a substrate that is formed from a semi-conductive material, the substrate defining a first major surface and a second major surface, the second major surface being opposed to the first major surface;
an epitaxial layer that is formed from a semi-conductive material, the epitaxial layer defining a first major surface and a second major surface, the second major surface being opposed to the first major surface, wherein the second major surface of the epitaxial layer is secured to the first major surface of the substrate;
an insulation layer, the insulation layer defining a first major surface and a second major surface, the second major surface being opposed to the first major surface, wherein the second major surface of the insulation layer is secured to the first major surface of the epitaxial layer;
a passivation layer, the passivation layer defining a first major surface and a second major surface, the second major surface being opposed to the first major surface, the second major surface of the passivation layer being secured to the first major surface of the insulation layer;
a first groove that extends into the first major surface of the insulation layer and at least to the first major surface of the epitaxial layer, the first groove being a continuous groove that extends inboard of and about a periphery of the chip;
a second groove that extends into the first major surface of the insulation layer and at least to the first major surface of the epitaxial layer, at least part of the second groove being disposed inboard of the first groove, wherein the second groove extends inboard of and about the periphery of the chip;
wherein at least part of the passivation layer extends into the first groove and wherein at least part of the passivation layer extends into the second groove.

2. The chip of claim 1, wherein the second groove is discontinuous.

3. The chip of claim 1 or claim 2, wherein the second groove is formed of a plurality of groove sections, and wherein, in plan view, each groove section is circular, polygonal, annular, cross-shaped, dot-shaped or linear.

4. The chip of any preceding claim, wherein the first groove follows a wave-shaped path.

5. The chip of any preceding claim, wherein the first groove follows a sinusoidally-shaped path, a square wave-shaped path, a triangular wave-shaped path, or a saw tooth-shaped path.

6. The chip of claim 3 and claim 4 or claim 5, wherein each groove section of the plurality of groove sections of the second groove are disposed between an inboard extremity and an outboard extremity of the path defined by the first groove .

7. The chip of claim 3, wherein each groove section of the second groove is linear in plan view, and wherein each groove section of the second groove extends parallel to or non-parallel to an adjacent portion of the first groove.

8. The chip of any preceding claim, further comprising a third groove that extends into the first major surface of the insulation layer, wherein:
the third groove extends inboard of and about a periphery of the chip at least part of the passivation layer extends into the third groove; and
the third groove is a continuous groove.

9. The chip of claim 7 and claim 8, wherein the third groove is disposed inboard of the first groove and inboard of the second groove, and wherein each groove section of the second groove extends non-parallel to an adjacent portion of the first groove, and wherein each groove section of the second groove adjoins and extends between the first groove and the third groove.

10. The chip of any of claims 1 to 7 and claim 8, wherein the third groove is disposed outboard of the first groove.

11. The chip of claim 1, wherein the second groove is continuous.

12. The chip of claim 11, wherein the first groove follows a wave-shaped path that defines a plurality apexes and the second groove follows a wave-shaped path that defines a plurality of apexes, and wherein alternative apexes of the first groove adjoin alternative apexes of the second groove.

13. The chip of any preceding claim, wherein the second groove is disposed inboard of the first groove.

14. The chip of any preceding claim, wherein the passivation layer is formed from polyimide.

15. A method of manufacturing a chip for a semi-conductor device, the method comprising:
providing a substrate that defines a first major surface and a second major surface, the second major surface being generally opposed to the first major surface, wherein the substrate is formed from a semi-conductive material;
providing an epitaxial layer that defines a first major surface and a second major surface, the second major surface being generally opposed to the first major surface, wherein the epitaxial layer is formed from a semi-conductive material and comprises a plurality of active cells, wherein the epitaxial layer is provided such that the second major surface of the epitaxial layer is secured to the first major surface of the substrate;
providing an insulation layer that defines a first major surface and a second major surface, the second major surface being generally opposed to the first major surface;
securing the second major surface of the insulation layer to the first major surface of the epitaxial layer;
applying a first photolithography resist layer to the first major surface of the insulation layer and subsequently patterning the first photolithography resist layer;
forming a plurality of recesses that extend through the insulation layer and into the substrate, the position of the plurality of recesses corresponding to a respective active cell of the plurality of active cells;
forming a first groove that extends into the first major surface of the insulation layer and at least to the epitaxial layer, the first groove being a continuous groove that extends inboard of and about a periphery of the chip; and
forming a second groove that extends into the first major surface of the insulation layer and at least to the epitaxial layer, at least part of the second groove being disposed inboard of the first groove, wherein the second groove extends inboard of and about the periphery of the chip;
wherein the pattern that is applied to the first photolithography resist layer corresponds to the plurality of recesses, the first groove, and the second groove;
wherein the method further comprises:
removing the first photolithography resist layer;
providing a conductive layer, the conductive layer defining a first side and a second side, the first side of the conductive layer being secured to the first major surface of the insulation layer and extending into the plurality of recesses, the first groove, and the second groove;
applying a second photolithography resist layer to the first side of the conductive layer and subsequently patterning the second photolithography resist layer; and
removing the conductive layer from the region or regions corresponding to the first groove and the second groove and from within the first groove and the second groove;
wherein the pattern that is applied to the second photolithography resist layer corresponds to the region or regions corresponding to the first groove and the second groove;
wherein the method further comprises:
removing the second photolithography resist layer; and
providing a passivation layer, the passivation layer being secured to the second side of the conductive layer and extending into the first groove and the second groove.
